# EUROPEAN PATENT SPECIFICATION

(11) **EP 1 916 101 B1**
(45) Date of publication and mention of the grant of the patent: **18.11.2009**
(21) Application number: 07123023.9
(22) Date of filing: 13.08.2003
(51) Int. Cl.: B41C 1/10, B41N 3/00, G03F 7/26

(54) **Method for postbaking a lithographic printing plate**
Verfahren zum Nacheinbrennen lithographischer Druckplatten
Procédé de post-cuisson d'une plaque d'impression lithographique

(43) Date of publication of application: 30.04.2008
(62) Divisional of application: 03102530.7
(73) Proprietor: Agfa Graphics N.V., 2640 Mortsel (BE)
(72) Inventor: Verschueren, Eric, 2640, Mortsel (BE); Van Damme, Marc, 2640, Mortsel (BE)

(56) References cited:
- WO-A-2005/015318
- DE-A1- 2 201 936
- DE-A1- 10 035 430
- DE-B1- 2 648 438
- GB-A- 1 330 139
- GB-A- 2 205 419
- WEISMAN D.W.: "Infrared drying and curing systems" 1999, ELSEVIER SCIENCE PUBLISHING , NEW YORK 5 , XP002473218 * pages 362,364 * * pages 366-368 *

## Description

### FIELD OF THE INVENTION

The present invention relates to a method for preparing a lithographic printing plate.

### BACKGROUND OF THE INVENTION

Lithographic printing presses use a so-called printing master such as a printing plate which is mounted on a cylinder of the printing press. The master carries a lithographic image on its surface and a print is obtained by applying ink to said image and then transferring the ink from the master onto a receiver material, which is typically paper. In conventional, so-called "wet" lithographic printing, ink as well as an aqueous fountain solution (also called dampening liquid) are supplied to the lithographic image which consists of oleophilic (or hydrophobic, i.e. ink-accepting, water-repelling) areas as well as hydrophilic (or oleophobic, i.e. water-accepting, ink-repelling) areas. In so-called driographic printing, the lithographic image consists of ink-accepting and ink-abhesive (ink-repelling) areas and during driographic printing, only ink is supplied to the master.

Printing masters are generally obtained by the so-called computer-to-film method wherein various pre-press steps such as typeface selection, scanning, color separation, screening, trapping, layout and imposition are accomplished digitally and each color selection is transferred to graphic arts film using an image-setter. After processing, the film can be used as a mask for the exposure of an imaging material called plate precursor and after plate processing, a printing plate is obtained which can be used as a master.

A typical printing plate precursor for computer-to-film methods comprise a hydrophilic support and an image-recording layer of a photosensitive polymer layers which include UV-sensitive diazo compounds, dichromate-sensitized hydrophilic colloids and a large variety of synthetic photopolymers. Particularly diazo-sensitized systems are widely used. Upon image-wise exposure, typically by means of a film mask in a UV contact frame, the exposed image areas become insoluble and the unexposed areas remain soluble in an aqueous alkaline developer. The plate is then processed with the developer to remove the diazonium salt or diazo resin in the unexposed areas. So the exposed areas define the image areas (printing areas) of the printing master, and such printing plate precursors are therefore called 'negative-working'. Also positive-working materials, wherein the exposed areas define the non-printing areas, are known, e.g. plates having a novolac/naphtoquinone-diazide coating which dissolves in the developer only at exposed areas.

In addition to the above photosensitive materials, also heat-or infrared-sensitive printing plate precursors have become very popular. Such materials offer the advantage of daylight-stability and are especially used in the so-called computer-to-plate method wherein the plate precursor is directly exposed, i.e. without the use of a film mask. The material is exposed to heat or to infrared light and the generated heat triggers a (physico-)chemical process, such as ablation, polymerization, insolubilisation by cross-linking of a polymer, heat-induced solubilisation, decomposition, or particle coagulation of a thermoplastic polymer latex.

The known heat- or infrared-sensitive printing plate precursors typically comprise a hydrophilic support and a coating containing an oleophilic polymer, which is alkali-soluble in exposed areas (positive working material) or in non-exposed areas (negative working material) and an IR-absorbing compound. Such an oleophilic polymer is typically a phenolic resin.

The ink and fountain solution which are supplied to the plate during the printing process, may attack the coating and, consequently, the resistance of the coating against these liquids, hereinafter referred to as "chemical resistance", may affect the printing run length. The printing run length can be improved by heating the image formed on the support after developing and gumming process. The known process for post-baking a printing plate is carried out by heating the plate in a heating oven at a temperature of about 235°C to 270°C during a relatively long time of about 2 to 5 minutes, even upto 10 minutes. This time consuming baking process is unfavourable for those applications where a quick availability of lithographic printing plates with a high printing run length is required, e.g. in the preparation of newspaper printing plates. In this sector, the systems which are used for image-wise exposing printing plate precursors and for processing and gumming these precursors, are very complicated machines which are able to deliver upto 200 plates per hour. However, this high throughput is reduced due to the slow baking process. The speed of the baking step is substantially increased by the method as disclosed in the present invention and this method allows the preparation of lithographic printing plates with a high chemical resistance of the coating in a short period of time.

WO2005/015318 discloses a method for improving the durability of an image on an imaging material comprising directing infrared radiation upon exposed areas of a processed imaging material. The infrared radiation can be supplied by infrared lamps having a wavelength of about 780 nm to about 1400 nm and the radiation can be incident upon the plate for about 15 seconds to about 25 seconds.

GB 1 330 139 discloses a process for burning-in an exposed and developed layer of a sensitized printing plate, wherein the layer is heated by means of electro-magnetic radiation, directed towards the layer from a radiation source having a radiation area less than the layer surface area, there being relative movement between the plate and the source so that the entire surface of the layer is irradiated.

D.W. Weisman discloses in "Infrared drying and curing systems" (1999), Elsevier Science Publishing, New York 5, XP002473218, that infrared radiation can be used in curing and drying processes to provide control of color, gloss, texture and surface finish.

DE 100 35 430 discloses a thermal treatment method for drying or baking a photo varnish layer with electro-magnetic radiation, having a wavelength in the infrared range between 0.8 µm and 1.5 µm.

DE 1 955 378 discloses a method for baking an exposed and developed printing plate by heating the plate with electromagnetic radiation such as ultra-red radiation to a temperature of at least 180°C.

GB 2 205 419 discloses a method for heating of a processed lithographic printing plate with infra-red radiation whereby the resistance to solvent is increased. The method allows for the heating to be combined with development in a single automatic processing machine so that a separate baking machine is unnecessary.

DE 26 48 438 discloses a method for fixing of the printing areas of a metallic offset-printing plate by heating the plate with infrared radiation.

DE 2 201 936 discloses a method for making a printing plate wherein, after image wise exposing and processing, the adhesion of the coating on the printing areas to the metallic support is improved by heating the plate with infrared radiation on the back side of the plate, preferably less than 2 seconds.

### SUMMARY OF THE INVENTION

It is an aspect of the present invention to provide a process for making a lithographic printing plate comprising a baking step which is carried out within a dwell-time of less than 1 minute and wherein the chemical resistance of the coating against printing liquids and press chemicals is improved. This object is realized by the method as defined in claim 1.

Specific embodiments of the invention are defined in the dependent claims.

### DETAILED DESCRIPTION OF THE INVENTION

In order to obtain a lithographic printing plate with an improved printing run length, it is important to increase the chemical resistance of the photosensitive coating against the printing liquids such as the dampening liquid and ink, and against the press chemicals such as cleaning liquids for the plate, for the blanket and for the press rollers. These printing properties are affected by a heat treatment of the printing plate after developing the image-wise exposed printing plate precursor and optionally gumming the plate. This heat treatment, hereinafter also referred to as a "baking step" or "baking process" or "baking method" or "baking", is one of the most important ways to obtain these properties in a short period of time time.

In accordance with the present invention, there is provided a method for making a lithographic printing plate comprising the steps of: (i) providing a negative-working lithographic printing plate precursor comprising a photosensitive coating having hydrophobic thermoplastic polymer particles on a substrate having a hydrophilic surface, (ii) image-wise exposing said photosensitive coating, (iii) developing said exposed coating to form an image on said substrate and optionally gumming the plate and (iv) baking the image on the plate, wherein said baking step is carried out within a dwell-time of less than 1 minute, preferably less than 30 seconds, more preferably less than 10 seconds.

It is also an aspect of the present invention that this baking step is carried out by exposing the printing plate to an infrared radiation source, hereinafter also referred to as an "infrared emitter" or shortly "emitter". An infrared radiation source may be any device or system emitting infrared radiation. The wavelength of the emitter may range between 750 nm and 6 µm, preferably between 770 nm and 5 µm, more preferably between 770 nm and 3.5 µm and most preferably between 770 nm and 2 µm. The emitter radiates substantially infrared light, without excluding side radiation of wavelengths outside the infrared wavelength range. The peak wavelength of the emitter may be in the near infrared range (i.e. between 750 nm and 1.5 µm), in the middle infrared range (i.e. between 1.5 µm and 6 µm), in the short wave infrared range (i.e. between 750 nm and 2 µm) or in the medium wave infrared range (i.e. between 2 µm and 3.5 µm); in the near or short wave infrared ranges is preferred. The emitter may be an infrared lamp. The lamp may have a reflector. The reflector has preferably a parabolic or an elliptic configuration; an elliptic configuration is more preferred.

Infrared emitters, suitable for the present invention, may be selected from the following emitter types:
- MICOR-KIR-BANDSTRAHLER TYP LE/LP infrared emitters, available from MICOR GmbH, Kröfteler Strasse 11, Idstein-Heftrich, Germany,
- SHORT WAVE infrared emitter, available from HERAEUS NOBLELIGHT GmbH, Reinhard-Heraeus-Ring 7, Kleinostheim, Germany,
- INFRALIGHT-HALOGEN infrared emitter, available from HERAEUS NOBLELIGHT GmbH, Reinhard-Heraeus-Ring 7, Kleinostheim, Germany,
- CARBON infrared emitter, available from HERAEUS NOBLELIGHT GmbH, Reinhard-Heraeus-Ring 7, Kleinostheim, Germany,
- CARBON HIGH POWER infrared emitter, available from HERAEUS NOBLELIGHT GmbH, Reinhard-Heraeus-Ring 7, Kleinostheim, Germany,
- CARBON TWIN infrared emitter, available from HERAEUS NOBLELIGHT GmbH, Reinhard-Heraeus-Ring 7, Kleinostheim, Germany.

Typical infrared emitters are preferably characterised by one or more of the following specifications or configurations: the length of the emitter may vary between 150 mm and 5 m; the voltage of the emitter may vary between 57.5 V and 600 V; the power output at maximum current may vary between 180 W and 15 kW; the mean linear power density may vary between 16 W/cm and 70 W/cm; the maximum power density may vary between 20 kW/m² and 190 kW/m²; the filament temperature of the emitter may up to 2200°C; the emitter may have a parabolic or elliptic reflector, optionally with a gold coating; the emitter may have a one-side or two-side connection; the emitter may have a twin tube emitter; the working of the emitter may be controlled, timed and/or adjusted by means of a control system.

In accordance with a specific embodiment of the present invention, the baking step is carried out by exposing the printing plate to at least one of said infrared emitting lamps. This baking process may be carried out in a static or dynamic configuration; a dynamic configuration is preferred.

In accordance with a specific embodiment of the present invention, the baking step is carried out by the following steps: radiating the printing plate to an emitter, and transporting the printing plate relative to the emitter. These two steps may be carried out separately, for example, transporting the plate relative to the emitter and then radiate the plate, or, by preference, these two steps are carried out simultaneously, for example, radiating the plate while transporting the plate relative to the emitter. In these configurations, at least one emitter is used, but two or more emitters of the same or different type, optionally in a serial configuration, may also used. The specifications and configuration of each emitter are chosen corresponding with the configuration wherein the baking step is carried out, such that the plate is homogeneously heated and sufficiently high in order to obtain a high chemical resistance.

In a dynamic configuration, the effective time of radiation of the plate and the intensity of radiation are important parameters for the efficiency of the baking process. The effective time of radiation of the plate may be defined for each emitter by the dwell-time. The dwell-time is the ratio of the exposure breadness of the emitter over the relative transporting speed of the plate to the emitter. The exposure breadness of the emitter may depend on the type of the emitter, the type of the reflector and the distance to the plate. Depending on the intensity of radiation, the relative transporting speed of the plate to the emitter(s) may vary between 0.5 m/minute and 20 m/minute, more specific between 1 m/minute and 15 m/minute, most specific between 2 m/minute and 10 m/minute. The value of the dwell-time for each emitter is lower than 1 minute, preferably lower than 30 seconds, more preferably lower than 10 seconds.

In this dynamic configuration the printing plate may be mounted in an isolated manner to prevent heat conduction to the environment. The printing plate may preferably be isolated by mounting a Teflon-material, such as a foil or a web, between the plate and the tranporting means.

In order to obtain a high chemical resistance, the coating on the plate exceeds a threshold temperature during the heating step. The threshold temperature depends on the type of the coating, more specific on the type of the chemical compounds used in the coating, and may also depend on the type of the surface of the support of the plate or on the type of a subbing layer present between the support and the coating. A typical example of such a threshold temperature may be a value above 100°C or above 150°C or even more above 200°C. The temperature of the coating may not exceed an upperlimit value where the coating starts decomposing, degrading or carbonating or where the coating starts ablating of the support. A typical example of an upperlimit temperature may be about 800°C, more precisely about 600°C. Typically, but not limited thereto, the coating of the plate may reach a temperature of above 120°C, more specific above 150°C, even more specific above 200°C. In order not to exceed the upperlimit temperature of the coating it is important to chose, in correspondence with the selected dwell-time for each emitter, the specifications and configuration of the emitter(s).

In another preferrred embodiment of the present invention, the baking process comprises the following steps: radiating the printing plate while the printing plate is transported to the emitter wherein the emitter is mounted in a fixed manner and the plate transports during the radiation. The plate may be transported in any direction, preferably in a horizontal direction, a vertical direction or a tilt direction; a horizontal direction is preferred. The position of the emitter may be preferably mounted above or beside the plate depending on the chosen transport direction (horizontally, vertically or tilt). The most preferred configuration is a horizontal transport of the plate with an emitter positionned above the coated side of the plate.

By the use of an emitter with an elliptic reflector the highest intensity of radiation may be obtained at the focus distance of the elliptic reflector. The printing plate may be very efficient heated when the coating of the plate is placed at this focus distance to the emitter; this configuration is preferred when an elliptic reflector is used in the baking step.

In order to obtain a shorter period of time for carrying out the baking step, resulting in a high chemical resistance of the coating, the specifications and configurations for each emitter are selected in such a way that the intensity of radiation on the coating in correspondence with the relative speed of plate to the emitter is sufficiently high such that the coating reaches its threshold temperature. In accordance to the present invention, the baking step is carried out within a dwell-time of less than 1 minute, preferably less than 30 seconds and more preferably less than 10 seconds.

In another embodiment of the present invention, an apparatus for baking an image, obtained after developing an image-wise exposed photosensitive coating on a substrate having a hydrophilic surface, is disclosed, wherein said apparatus comprises an infrared radiation source, **characterised in that** said infrared radiation source is a near infrared lamp or a middle infrared lamp. Configurations as described above for dynamic and static configurations may preferably used in this apparatus. In accordance to another embodiment of the present invention, a processor for developing an image-wise exposed photosensitive coating on a substrate having a hydrophilic surface, is disclosed, wherein the processor comprises the apparatus for baking an image as disclosed above. The baking apparatus may be preferably integrated in a processor. In this configuration, the exposed photosensitive coating is developped and, after developing, is further transported relative to the infrared radiation source. The baking process is carried out in a static or dynamic configuration; the dynamic configuration is preferred. The baking process is carried out within a dwell-time of less than 1 minute. In a dynamic configuration, the baking process is carried out within a dwell-time varying from 1 to 50 seconds depending on the processor speed and the type of emitter(s) which is (are) used.

The baking process may be also carried out in a static configuration by the use of one or more emitters. In a preferred configuration the emitter or emitters are positionned above the coating of the plate. The specifications and configuration of each emitter are chosen in corresponding with the intensity of radiation, needed to heat the plate homogeneously and sufficiently high in order to obtain a high chemical resistance of the coating. In the static configuration the effective time of radiation of the plate is defined as the dwell-time.

In another embodiment of the present invention, the baking step is carried out by exposing the printing plate to an infrared radiation source in combination with an ultraviolet radiation source. The ultraviolet radiation source is preferably an UV lamp. The infrared lamp in this baking process may be combined with an UV lamp in order to further improve the efficiency of the baking process. Under this combination any configuration is understood whereby the printing plate is simultaneously or successively exposed by an IR radiation source and an UV radiation source.

Types of UV radiation sources which can be used in these combinations are Medium Pressure Mercury Arc lamps, with a power range of 1kW to 31kW, Metal Halide lamps, doped with Gallium, Metal Halide lamps, doped with Iron, or Excimer UV lamps. Examples of such UV radiation sources are the AMBA UV Curing Lamps, commercially available from HERAEUS NOBLELIGHT GmbH, Reinhard-Heraeus-Ring 7, Kleinostheim, Germany.

This chemical resistance of the coating can be measured by the test as described in the examples.

The lithographic printing plate precursor may comprise a photosensitive coating on a substrate having a hydrophilic surface. The photosensitive coating may comprise at least one image-sensitive layer which may be sensitive to UV light, violet light, visible light or infrared light. The image-sensitive layer of the photosensitive coating may comprise at least a light absorbing compound corresponding with the wavelength of the light used by the image-wise recording. Optionally, in addition to this light absorbing compound, the photosensitive coating may further comprise an infrared absorbing compound, suitable for absorbing IR-radiation during the baking step. This infrared absorbing compound may increase the efficiency of the baking process.

The photosensitive coating may also be sensitive to heat. Typical for such a heat-sensitive coating is that the image-sensitive layer comprises an infrared light absorbing compound, which, on image-wise exposing to infrared light, is able to convert the absorbed infrared light into heat. According to a preferred embodiment, the photosensitive coating is sensitive to infrared light or to heat and this coating comprises preferably an infrared absorbing compound.

The photosensitive coating provided on the hydrophilic support, is preferably sensitive to infrared light or heat and can preferably be handled in normal working lighting conditions (daylight, fluorescent light) for several hours. This coating preferably does not contain UV-sensitive compounds which have an absorption maximum in the wavelength range of 200 nm to 400 nm such as diazo compounds, photoacids, photoinitiators, quinone diazides, or sensitizers. Preferably the coating neither contains compounds which have an absorption maximum in the blue and green visible light wavelength range between 400 and 600 nm.

The photosensitive coating may be composed of at least one image-sensitive layer, hereinafter also referred to as image-recording layer. The coating may also contain one or more additional layer(s), adjacent to the image-recording layer. Besides the layers discussed hereafter, the coating may further comprise e.g. a "subbing" layer which improves the adhesion of the coating to the support, a covering layer which protects the coating against contamination or mechanical damage, and/or a light-to-heat conversion layer which comprises an infrared light absorbing compound.

After exposure, the material is developed. "Developing" and "processing" are used herein as equivalent terms. Development can be carried out by supplying to the coating a liquid comprising a hydrophilic phase, thereby removing the coating from the support at non-exposed areas, of the negative working plate. Said liquid can be selected from the group consisting of water, an aqueous liquid, gum, fountain and single-fluid ink. The material can be developed by supplying fountain and/or printing ink, preferably by supplying first fountain and subsequently ink. This method is preferably used in combination with an on-press exposure step. Another development method, also suitable for on-press development, especially in driographic presses, is performed by supplying single-fluid ink. Single-fluid inks which are suitable for use in the method of the present invention have been described in US 4,045,232 and US 4,981,517. A suitable single-fluid ink comprises an ink phase, also called the hydrophobic or oleophilic phase, and a polyol phase as described in WO 00/32705. More information on the development with single-fluid ink can be found in EP-A no. 01000633, filed on 15.11.2001.

When exposed in an off-press plate-setter, the material can be processed on-press by supplying ink and/or fountain as mentioned before or off-press, e.g. by supplying water, an aqueous liquid or a gum solution.

After the development or simultaneously with the development, the plate is optionally gummed. A gum solution is typically an aqueous liquid which comprises one or more surface protective compounds that are capable of protecting the lithographic image of a printing plate against contamination or damaging. Suitable examples of such compounds are film-forming hydrophilic polymers or surfactants. More information on the development with a gum solution can be found in EP-A no. 02100226, filed on 06.03.2002.

After developing or gumming, the plate can be dried before the baking process or can be dried during the baking process itself.

In the negative-working lithographic printing plate precursor, the coating further contains hydrophobic thermoplastic polymer particles. Specific examples of suitable hydrophobic polymers are e.g. polyethylene, poly(vinyl chloride), poly(methyl (meth)acrylate), poly(ethyl (meth)acrylate), poly(vinylidene chloride), poly(meth)acrylonitrile, poly(vinyl carbazole), polystyrene or copolymers thereof. The thermoplastic polymer may preferably comprise at least 50 wt.% of polystyrene, and more preferably at least 60 wt.% of polystyrene. In order to obtain sufficient resistivity against mechanical damage and towards press chemicals, such as the hydrocarbons used in plate cleaners, the thermoplastic polymer preferably comprises at least 5 wt.%, more preferably at least 30 wt.% of nitrogen containing monomeric units or of units which correspond to monomers that are characterized by a solubility parameter larger than 20, such as (meth)acrylonitrile or monomeric units comprising sulfonamide and/or phthalimide pendant groups. Other suitable examples of such nitrogen containing monomeric units are disclosed in European Patent Application no. 01000657, filed on 23.11.2001. A specific embodiment of the hydrophobic thermoplastic polymer is a homopolymer or a copolymer of (meth)acrylonitrile and/or styrene, e.g. a copolymer consisting of styrene and acrylonitrile units in a weight ratio between 1:1 and 5:1 (styrene:acrylonitrile). A 2:1 or 3:2 ratio provides excellent results.

The weight average molecular weight of the thermoplastic polymer particles may range from 5,000 to 1,000,000 g/mol. The hydrophobic particles preferably have a number average particle diameter below 200 nm, more preferably between 10 and 100 nm. The amount of hydrophobic thermoplastic polymer particles contained in the image-recording layer is preferably between 20 wt.% and 65 wt.% and more preferably between 25 wt.% and 55 wt.% and most preferably between 30 wt.% and 45 wt.%.

The hydrophobic thermoplastic polymer particles can be provided as a dispersion in an aqueous coating liquid of the image-recording layer and may be prepared by the methods disclosed in US 3,476,937. Another method especially suitable for preparing an aqueous dispersion of the thermoplastic polymer particles comprises:
- dissolving the hydrophobic thermoplastic polymer in an organic water immiscible solvent,
- dispersing the thus obtained solution in water or in an aqueous medium and
- removing the organic solvent by evaporation.

The image-recording layer further may comprise a hydrophilic binder, e.g. homopolymers and copolymers of vinyl alcohol, acrylamide, methylol acrylamide, methylol methacrylamide, acrylic acid, methacrylic acid, hydroxyethyl acrylate, hydroxyethyl methacrylate or maleic anhydride/vinylmethylether copolymers. The hydrophilicity of the (co)polymer or (co)polymer mixture used is preferably the same as or higher than the hydrophilicity of polyvinyl acetate hydrolyzed to at least an extent of 60 percent by weight, preferably 80 percent by weight. Binders with carboxylic pendant groups, e.g. poly(meth)acrylic acid, are preferred.

Due to the heat generated during the exposure step, the hydrophobic thermoplastic polymer particles fuse or coagulate so as to form a hydrophobic phase which corresponds to the printing areas of the printing plate. Coagulation may result from heat-induced coalescence, softening or melting of the thermoplastic polymer particles. There is no specific upper limit to the coagulation temperature of the thermoplastic hydrophobic polymer particles, however the temperature should be sufficiently below the decomposition temperature of the polymer particles. Preferably the coagulation temperature is at least 10°C below the temperature at which the decomposition of the polymer particles occurs. The coagulation temperature is preferably higher than 50°C, more preferably above 100°C.

After developing and optionally gumming, the plate can be dried and baked. The baking process can proceed at a temperature above the coagulation temperature of the thermoplastic polymer.

The image-recording layer may also contain other ingredients such as additional binders, surfactants, colorants, development inhibitors or accelerators, and especially one or more compounds that are capable of converting infrared light into heat.

According to a more preferred embodiment, the lithogrphic printing plate precursor is image-wise exposed to infrared light, which is converted into heat by an infrared light absorbing agent, which may be a dye or pigment having an absorption maximum in the infrared wavelength range. The concentration of the sensitizing dye or pigment in the coating is typically between 0.25 and 10.0 wt.%, more preferably between 0.5 and 7.5 wt.% relative to the coating as a whole. Preferred IR-absorbing compounds are dyes such as cyanine or merocyanine dyes or pigments such as carbon black. A suitable compound is the following infrared dye:

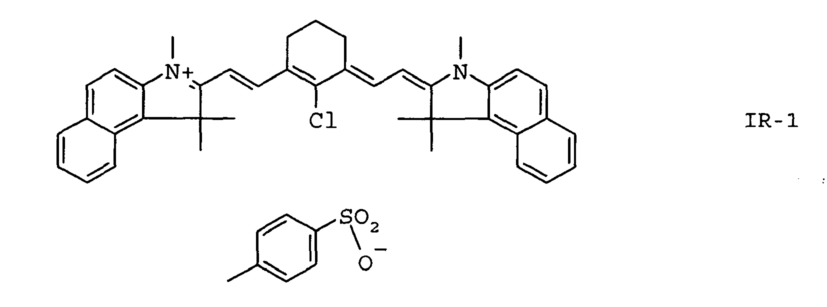

The coating may further contain an organic dye which absorbs visible light so that a perceptible image is obtained upon image-wise exposure and subsequent development. Such a dye is often called contrast dye or indicator dye. Preferably, the dye has a blue color and an absorption maximum in the wavelength range between 600nm and 750 nm. Although the dye absorbs visible light, it preferably does not sensitize the printing plate precursor, i.e. the coating does not become more soluble in the developer upon exposure to visible light. Suitable examples of such a contrast dye are the quaternized triarylmethane dyes. Another suitable compound is the following dye:

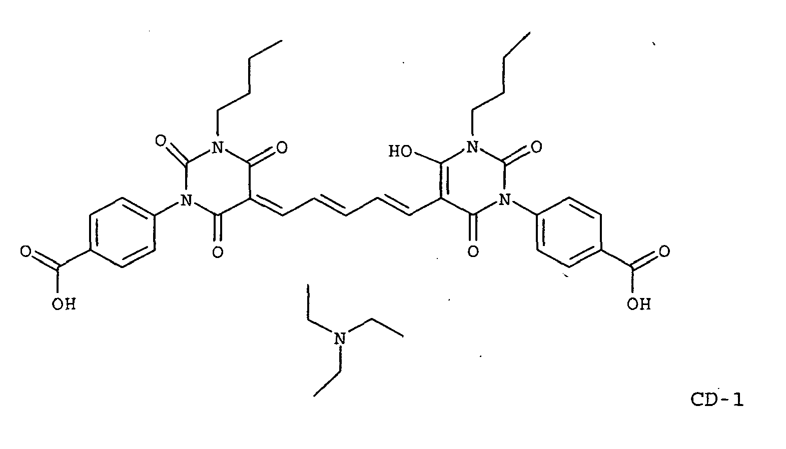

The infrared light absorbing compound and the contrast dye may be present in the layer comprising the hydrophobic polymer, and/or in the barrier layer discussed above and/or in an optional other layer. According to a highly preferred embodiment, the infrared light absorbing compound is concentrated in or near the barrier layer, e.g. in an intermediate layer between the layer comprising the hydrophobic polymer and the barrier layer.

The support has a hydrophilic surface or is provided with a hydrophilic layer. The support may be a sheet-like material such as a plate or it may be a cylindrical element such as a sleeve which can be slid around a print cylinder of a printing press. Preferably, the support is a metal support such as aluminum or stainless steel.

A particularly preferred lithographic support is an electrochemically grained and anodized aluminum support.

Graining and anodizing of aluminum lithographic supports is well known. The grained aluminum support used in the material of the present invention is preferably an electrochemically grained support. The acid used for graining can be e.g. nitric acid. The acid used for graining preferably comprises hydrogen chloride. Also mixtures of e.g. hydrogen chloride and acetic acid can be used.

The grained and anodized aluminum support may be post-treated to improve the hydrophilic properties of its surface. For example, the aluminum support may be silicated by treating its surface with a sodium silicate solution at elevated temperature, e.g. 95°C. Alternatively, a phosphate treatment may be applied which involves treating the aluminum oxide surface with a phosphate solution that may further contain an inorganic fluoride. Further, the aluminum oxide surface may be rinsed with an organic acid and/or salt thereof, e.g. carboxylic acids, hydroxycarboxylic acids, sulfonic acids or phosphonic acids, or their salts, e.g. succinates, phosphates, phosphonates, sulfates, and sulfonates. A citric acid or citrate solution is preferred. This treatment may be carried out at room temperature or may be carried out at a slightly elevated temperature of about 30 to 50°C. A further post-treatment involves rinsing the aluminum oxide surface with a bicarbonate solution. Still further, the aluminum oxide surface may be treated with polyvinylphosphonic acid, polyvinylmethylphosphonic acid, phosphoric acid esters of polyvinyl alcohol, polyvinylsulfonic acid, polyvinylbenzenesulfonic acid, sulfuric acid esters of polyvinyl alcohol, and acetals of polyvinyl alcohols formed by reaction with a sulfonated aliphatic aldehyde. It is further evident that one or more of these post-treatments may be carried out alone or in combination. More detailed descriptions of these treatments are given in GB-A- 1 084 070, DE-A- 4 423 140, DE-A- 4 417 907, EP-A- 659 909, EP-A- 537 633, DE-A- 4 001 466, EP-A- 292 801, EP-A- 291 760 and US-P- 4 458 005.

According to another embodiment, the support can also be a flexible support, which is provided with a hydrophilic layer, hereinafter called 'base layer'. The flexible support is e.g. paper, plastic film, thin aluminum or a laminate thereof. Preferred examples of plastic film are polyethylene terephthalate film, polyethylene naphthalate film, cellulose acetate film, polystyrene film, polycarbonate film, etc. The plastic film support may be opaque or transparent.

The base layer is preferably a cross-linked hydrophilic layer obtained from a hydrophilic binder cross-linked with a hardening agent such as formaldehyde, glyoxal, polyisocyanate or a hydrolyzed tetra-alkylorthosilicate. The latter is particularly preferred. The thickness of the hydrophilic base layer may vary in the range of 0.2 to 25 µm and is preferably 1 to 10 µm.

The hydrophilic binder for use in the base layer is e.g. a hydrophilic (co)polymer such as homopolymers and copolymers of vinyl alcohol, acrylamide, methylol acrylamide, methylol methacrylamide, acrylic acid, methacrylic acid, hydroxyethyl acrylate, hydroxyethyl methacrylate or maleic anhydride/vinylmethylether copolymers. The hydrophilicity of the (co)polymer or (co)polymer mixture used is preferably the same as or higher than the hydrophilicity of polyvinyl acetate hydrolyzed to at least an extent of 60% by weight, preferably 80% by weight.

The amount of hardening agent, in particular tetraalkyl orthosilicate, is preferably at least 0.2 parts per part by weight of hydrophilic binder, more preferably between 0.5 and 5 parts by weight, most preferably between 1 parts and 3 parts by weight.

The hydrophilic base layer may also contain substances that increase the mechanical strength and the porosity of the layer. For this purpose colloidal silica may be used. The colloidal silica employed may be in the form of any commercially available water dispersion of colloidal silica for example having an average particle size up to 40 nm, e.g. 20 nm. In addition inert particles of larger size than the colloidal silica may be added e.g. silica prepared according to Stöber as described in J. Colloid and Interface Sci., Vol. 26, 1968, pages 62 to 69 or alumina particles or particles having an average diameter of at least 100 nm which are particles of titanium dioxide or other heavy metal oxides. By incorporating these particles the surface of the hydrophilic base layer is given a uniform rough texture consisting of microscopic hills and valleys, which serve as storage places for water in background areas.

Particular examples of suitable hydrophilic base layers for use in accordance with the present invention are disclosed in EP-A- 601 240, GB-P- 1 419 512, FR-P- 2 300 354, US-P- 3 971 660, and US-P- 4 284 705.

It is particularly preferred to use a film support to which an adhesion improving layer, also called support layer, has been provided. Particularly suitable adhesion improving layers for use in accordance with the present invention comprise a hydrophilic binder and colloidal silica as disclosed in EP-A- 619 524, EP-A- 620 502 and EP-A- 619 525. Preferably, the amount of silica in the adhesion improving layer is between 200 mg/m² and 750 mg/m². Further, the ratio of silica to hydrophilic binder is preferably more than 1 and the surface area of the colloidal silica is preferably at least 300 m²/gram, more preferably at least 500 m²/gram.

The printing plate precursor of the present invention can be exposed to infrared light with LEDs or a laser. Preferably, a laser emitting near infrared light having a wavelength in the range from about 750 to about 1500 nm is used, such as a semiconductor laser diode, a Nd:YAG or a Nd:YLF laser. The required laser power depends on the sensitivity of the image-recording layer, the pixel dwell time of the laser beam, which is determined by the spot diameter (typical value of modern plate-setters at 1/e² of maximum intensity : 10-25 µm), the scan speed and the resolution of the exposure apparatus (i.e. the number of addressable pixels per unit of linear distance, often expressed in dots per inch or dpi; typical value : 1000-4000 dpi).

Two types of laser-exposure apparatuses are commonly used: internal (ITD) and external drum (XTD) plate-setters. ITD plate-setters for thermal plates are typically characterized by a very high scan speed up to 1500 m/sec and may require a laser power of several Watts. The Agfa Galileo T is a typical example of a plate-setter using the ITD-technology. XTD plate-setters operate at a lower scan speed typically from 0.1 m/sec to 10 m/sec and have a typical laser-output-power per beam from 20 mW up to 500 mW. The Creo Trendsetter plate-setter family and the Agfa Excalibur plate-setter family both make use of the XTD-technology.

The known plate-setters can be used as an off-press exposure apparatus, which offers the benefit of reduced press down-time. XTD plate-setter configurations can also be used for on-press exposure, offering the benefit of immediate registration in a multi-color press. More technical details of on-press exposure apparatuses are described in e.g. US 5,174,205 and US 5,163,368.

In the development step, the non-image areas of the coating can be removed by immersion in an aqueous alkaline developer, which may be combined with mechanical rubbing, e.g. by a rotating brush. The developer preferably has a pH above 10, more preferably above 12. The development step may be followed by a rinsing step, a gumming step, a drying step and/or a post-baking step.

The printing plate thus obtained can be used for conventional, so-called wet offset printing, in which ink and an aqueous dampening liquid is supplied to the plate. Another suitable printing method uses so-called single-fluid ink without a dampening liquid. Single-fluid ink consists of an ink phase, also called the hydrophobic or oleophilic phase, and a polar phase which replaces the aqueous dampening liquid that is used in conventional wet offset printing. Suitable examples of single-fluid inks have been described in US 4,045,232; US 4,981,517 and US 6,140,392. In a most preferred embodiment, the single-fluid ink comprises an ink phase and a polyol phase as described in WO 00/32705.

### EXAMPLES

### Preparation of the lithographic printing plate precursor TG, a negative-working thermal plate, sensitised for 830 nm:

Onto an electrochemically roughened and anodically oxidized aluminum sheet, the surface of which has been rendered hydrophilic by treatment with an aqueous solution of polyvinyl phosphonic acid (oxide weight 3 g/m²) an image-recording layer was coated from an aqueous coating solution at a wet thickness of 30 g/m². After drying, the layer consisted of:
- 600 mg/m² of particles of a copolymer of styrene and acrylonitrile (weight ratio 60/40), having an average particle size of 65 nm and stabilized with an anionic wetting agent,
- 60 mg/m² of infrared absorbing Dye 1,
- and 120 mg/m² of polyacrylic acid (Glascol D15 from Allied Colloids, molecular weight 2.7x10⁷ g/mole).

The infrared absorbing Dye 1 is

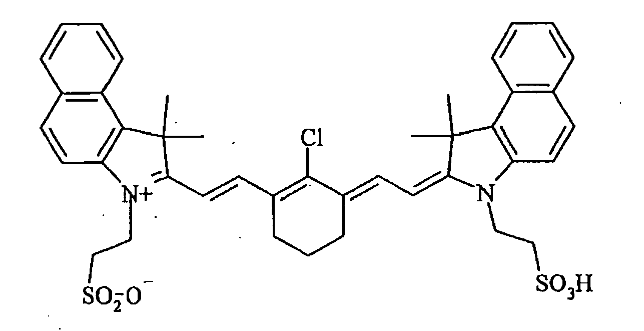

The plate precursor thus obtained was exposed with a Creo Trendsetter (plate-setter available from Creo, Burnaby, Canada), operating at 330 mJ/cm² and 150 rpm. After imaging, the plate was developed with RC520 (commercially available gumming solution from Agfa).

### Procedure for baking process by a dynamic IR-exposing, hereinafter referred to as "Dynamic IR":

The printing plate precursor TG, as prepared above, was heated with a MICOR-KIR-KASSETTE 36 kW.
The specifications and configuration of the emitter were the following:
- exposure broadness : 310 mm
- power: 100 % i.e. 36 kW
- distance of the emitter to the coating of the plate: 50 mm
- speed of the plate: between 5 and 3 m/minute as indicated in Table 2.

### Procedure for baking process by static oven-heating, hereinafter referred to as "Static Oven":

The printing plate precursor TG, as prepared above, was heated in a oven, heated at 235°C during 5 minutes.

### Procedure for baking process by dynamic oven-heating, hereinafter referred to as "Dynamic Oven":

The printing plate precursor TG, as prepared above, was heated with a Haase Oven type OG15 at a temperature setting of 270°C and a speed of 0.7 m/min, corresponding to a dwell-time of the baking step of 150 seconds.

### Test for chemical resistance:

For measuring the chemical resistance, the following corrector solution was selected:
- KP273: Test Corrector Solution for negative and positive thermal plate printing precursor TG, TS-1 and TS-2;
- KN250: Test Corrector Solution for negative violet photopolymer plate printing precursor VPP.

The chemical resistance was tested by contacting a droplet of the Test Corrector Solution on the baked plates. After 3 minutes, the droplet was removed from the coating with a cotton pad. The attack on the coating, due to the Test Corrector Solution, was rated by visual inspection as follows:
- 0: no attack,
- 1: changed gloss of the coating's surface,
- 2: small attack of the coating (thickness is decreased),
- 3: heavy attack of the coating,
- 4: completely dissolved coating.

The higher the rating, the less is the chemical resistance of the coating. The results for the Test Corrector Solution, hereinafter referred to as "T-C-S", on the coating of each printing plate precursor are summarised in Table 2. The table contains also information about the type of the printing plate precursor, the type of the baking process, the speed of the IR-baking process and the dwell-time of the baking process.

**Table 2:**

| Example number | Type printing plate precursor | Type baking step | Speed IR post-baking (m/min) | Dwell time (sec.) | Chemical Resistance (for T-C-S KP273) |
|---|---|---|---|---|---|
| Comparative example 1 | TG | No | - | - | 4 |
| Comparative example 2 | TG | Static Oven | - | 300 | 0 |
| Comparative example 3 | TG | Dynamic Oven | - | 150 | 0 |
| Example 1 | TG | Dynamic IR | 5.0 | 3.7 | 0 |
| Example 2 | TG | Dynamic IR | 4.0 | 4.6 | 0 |
| Example 3 | TG | Dynamic IR | 3.5 | 5.3 | 0 |
| Example 4 | TG | Dynamic IR | 3.7 | 5.0 | 0 |
| Example 5 | TG | Dynamic IR | 3.8 | 4.9 | 0 |
| Example 6 | TG | Dynamic IR | 3.0 | 6.2 | 0 |

The Examples in Table 2 demonstrate that the baking step, carried out within a dwell-time of less than 7 seconds by a dynamic IR-exposing apparatus, is able to form a TG-printing plate, with an excellent chemical resistance.

## Claims

1. Method for making a lithographic printing plate comprising the steps of
- providing a negative-working lithographic printing plate precursor comprising a photosensitive coating having hydrophobic thermoplastic polymer particles, on a substrate having a hydrophilic surface,
- image-wise exposing said photosensitive coating,
- developing said exposed coating to form an image on said substrate and optionally gumming the plate,
- baking the image on the plate,
**characterised in that** said baking step is carried out within a dwell-time of.less than 1 minute.

2. Method according to claim 1 wherein said baking step is carried out by exposing the printing plate to an infra-red radiation source.

3. Method according to claim 2 wherein said infra-red radiation source is a near infra-red lamp or a middle infra-red lamp.

4. Method according to claims 2 or 3 wherein said baking step is carried out by the following steps:
- radiating by an infra-red source, and
- transporting said printing plate relatively to said radiation source.

5. Method according to any of the preceding claims wherein said photosensitive coating comprises an infra-red absorbing compound.

6. Method according to claim 5 wherein said infra-red absorbing compound has an absorption maximum between 750 nm and 3000 nm.

7. Method according to any of the preceding claims wherein said photosensitive coating is an infra-red sensitive coating.

8. Method according to any of the preceding claims wherein said printing plate is isolated to prevent heat conduction to the environment.

9. Method according to any of claims 2 to 8 wherein said baking step is carried out by exposing the printing plate to an infra-red radiation source combined with an ultraviolet radiation source.

10. Method according to any of the preceding claims wherein said substate, having a hydrophilic surface, is an anodised aluminum plate.

## Patentansprüche

1. Ein Verfahren zur Herstellung einer lithografischen Druckplatte, das folgende Schritte umfasst :
- Bereitstellen einer negativarbeitenden lithografischen Druckplattenvorstufe mit einer auf einem Substrat mit einer hydrophilen Oberfläche angebrachten strahlungsempfindlichen Beschichtung, die Teilchen eines hydrophoben thermoplastischen Polymers enthält,
- bildmäßige Belichtung der strahlungsempfindlichen Beschichtung,
- Entwicklung der belichteten Beschichtung zur Erzeugung eines Bildes auf dem Substrat und eventuelles Gummieren der Platte und
- Einbrennen des Bildes auf der Platte,
**dadurch gekennzeichnet, dass** der Einbrennschritt innerhalb einer Verweilzeit von weniger als 1 Minute durchgeführt wird.

2. Verfahren nach Anspruch 1, **dadurch gekennzeichnet, dass** der Einbrennschritt darin besteht, die Druckplatte mittels einer Infrarotstrahlungsquelle zu belichten.

3. Verfahren nach Anspruch 2, **dadurch gekennzeichnet, dass** die Infrarotstrahlungsquelle eine nahe Infrarotlampe oder mittelwellige Infrarotlampe ist.

4. Verfahren nach Anspruch 2 oder 3, **dadurch gekennzeichnet, dass** der Einbrennschritt folgende Schritte umfasst :
- Bestrahlung mit einer Infrarotstrahlungsquelle und
- relativ zur Strahlungsquelle Fördern der Druckplatte.

5. Verfahren nach einem der vorstehenden Ansprüche, **dadurch gekennzeichnet, dass** die strahlungsempfindliche Beschichtung eine Infrarotlicht absorbierende Verbindung enthält.

6. Verfahren nach Anspruch 5, **dadurch gekennzeichnet, dass** die Infrarotlicht absorbierende Verbindung ein Absorptionsmaximum zwischen 750 nm und 3.000 nm aufweist.

7. Verfahren nach einem der vorstehenden Ansprüche, **dadurch gekennzeichnet, dass** die strahlungsempfindliche Beschichtung eine IR-empfindliche Beschichtung ist.

8. Verfahren nach einem der vorstehenden Ansprüche, **dadurch gekennzeichnet, dass** die Druckplatte isoliert ist, um Wärmeableitung zur Umgebung zu verhindern.

9. Verfahren nach einem der Ansprüche 2 bis 8, **dadurch gekennzeichnet, dass** der Einbrennschritt darin besteht, die Druckplatte mittels einer Kombination einer Infrarotstrahlungsquelle und einer Ultraviolettstrahlungsquelle zu belichten.

10. Verfahren nach einem der vorstehenden Ansprüche, **dadurch gekennzeichnet, dass** das Substrat mit einer hydrophilen Oberfläche eine anodisierte Aluminiumplatte ist.

## Revendications

1. Un procédé pour la confection d'une plaque d'impression, comprenant les étapes ci-après :
- la mise à disposition d'un précurseur de plaque d'impression lithographique à effet négatif comprenant un revêtement photosensible appliqué sur un substrat ayant une surface hydrophile et contenant des particules d'un polymère hydrophobe thermoplastique,
- l'exposition sous forme d'image du revêtement photosensible,
- le développement du revêtement exposé afin de former une image sur le substrat, et le gommage éventuel de la plaque, et
- la cuisson de l'image sur la plaque,
**caractérisé en ce que** l'étape de cuisson est effectuée en appliquant un temps de séjour inférieur à 1 minute.

2. Procédé selon la revendication 1, **caractérisé en ce que** l'étape de cuisson comprend l'exposition de la plaque d'impression à une source de rayonnement infrarouge.

3. Procédé selon la revendication 2, **caractérisé en ce que** la source de rayonnement infrarouge est une lampe à rayonnement infrarouge proche ou une lampe à rayonnement infrarouge à ondes moyennes.

4. Procédé selon la revendication 2 ou 3, **caractérisé en ce que** l'étape de cuisson comprend les étapes suivantes :
- l'irradiation à l'aide d'une source de rayonnement infrarouge et
- le transport de la plaque d'impression par devant la source de rayonnement.

5. Procédé selon l'une quelconque des revendications précédentes, **caractérisé en ce que** le revêtement photosensible contient un composé absorbant les rayons infrarouges.

6. Procédé selon la revendication 5, **caractérisé en ce que** le composé absorbant les rayons infrarouges présente un maximum d'absorption compris entre 750 nm et 3.000 nm.

7. Procédé selon l'une quelconque des revendications précédentes, **caractérisé en ce que** le revêtement photosensible est un revêtement sensible à l'infrarouge.

8. Procédé selon l'une quelconque des revendications précédentes, **caractérisé en ce que** la plaque d'impression est isolée afin d'éviter toute dissipation de chaleur dans le milieu ambiant.

9. Procédé selon l'une quelconque des revendications 2 à 8, **caractérisé en ce que** l'étape de cuisson comprend une exposition de la plaque d'impression à une combinaison d'une source de rayonnement infrarouge et d'une source de rayonnement ultraviolet.

10. Procédé selon l'une quelconque des revendications précédentes, **caractérisé en ce que** le substrat ayant une surface hydrophile est une plaque d'aluminium anodisée.
